Europäisches Patentamt

European Patent Office

Office européen des brevets

(11) Publication number: **0 515 043 A2**

# EUROPEAN PATENT APPLICATION

(21) Application number: **92303747.7**

(22) Date of filing: **24.04.92**

(51) Int. Cl.⁵: **H03K 19/177**

(30) Priority: **24.05.91 US 705004**

(43) Date of publication of application:
**25.11.92 Bulletin 92/48**

(84) Designated Contracting States:
**DE FR GB IT**

(71) Applicant: **ACTEL CORPORATION**
**955 East Arques Avenue**
**Sunnyvale California 94086(US)**

(72) Inventor: **Gopisetty, Runip**
**4221 Norwalk Drive, Nr. BB-305**
**San Jose, California 95129(US)**

(74) Representative: **Williams, Trevor John**
**J.A. KEMP & CO. 14 South Square Gray's Inn**
**London WC1R 5LX(GB)**

(54) **Direct interconnect for functional circuit module array.**

(57) In a direct interconnect structure for interconnecting neighboring functional circuit modules in a user-programmable circuit array, at least one input lead of a first functional circuit module in an array of functional circuit modules is connected to a first input of a multiplexer circuit associated with the functional circuit module. The output of the multiplexer circuit is connected to the input node with which the input lead is associated in the first functional circuit module. A second input of the multiplexer circuit is connected to an internal node of a second, neighboring functional circuit module. The internal node is located upstream from the output buffer of the second functional circuit module. Other inputs to the multiplexer may be connected to internal nodes in other (third, and fourth etc.) neighboring functional circuit modules. By programming the multiplexer control inputs using the same programmable elements which are used to effect the interconnections in the general interconnect architecture of the array, the input node of the first functional circuit module may be connected to the input lead and to other circuit nodes in the array via the general interconnect structure, or may be connected to the internal nodes of one of a number of neighboring functional circuit modules in a manner which bypasses both the output buffer stage of the other functional module and the general interconnect structure.

FIG. 1

## BACKGROUND OF THE INVENTION

### 1. Field Of The Invention

The present invention relates to integrated circuit technology and in particular to user-programmable integrated circuit technology. More specifically, the present invention relates to an architecture for achieving direct connections between different functional circuit modules in an integrated circuit containing a plurality of functional circuit modules which may be programmably interconnected by a user to form desired electronic circuits.

### 2. The Prior Art

A typical integrated circuit uses a network of metal interconnects between the individual semiconductor components which are patterned with standard photolithographic processes during wafer fabrication. Multiple levels of metalized patterns may be used to increase the flexibility of the interconnects. For example, in very Large Scale Integration, higher density and more complex wiring networks are needed and multiple metal layers are often utilized.

It has long been recognized that user-programmable interconnect techniques or manufacturer programmability just prior to shipment allow lower tooling costs and faster delivery time. Numerous vehicles have been proposed for accomplishing user programmability of complex circuits.

One technique for providing user-programmable integrated circuits uses lasers to make or break pre-patterned metal interconnects between an array of logic cells. This is usually performed on the finished wafer prior to assembly or actually in an open package. Another approach uses an array of uncommitted interconnect metal lines using antifuses consisting of an amorphous silicon alloy sandwiched into insulation holes between third and fourth metal layers to provide electrically programmable links.

Such systems of interconnect may be used in analog or digital integrated circuits fabricated using bipolar, MOS or other semiconductor technologies. The laser approach requires sophisticated programming equipment and is fairly slow, requiring many hours to pattern one device having a complexity of two-three thousand circuit elements.

Various techniques for realizing electrically programmable integrated circuits which may be configured by an end user are known in the art. Examples of the user-programmable architectures known in the prior art are found in United States Patent No. 4,758,745 to El Gamal et al. and United States Patent No. 4,873,459 to El Gamal et al., which disclose an architecture for interconnection of functional circuit modules using antifuse technology. Other examples of approaches to interconnection of arrays of functional circuit modules are shown in United States Patent No. 4,670,749 to Freeman, United States Patent No.4,870,302 to Freeman, which utilize MOS transistors controlled by memory elements or registers.

Regardless of the interconnection method employed, programming of interconnections between functional circuit modules is frequently implemented such that the output of one functional circuit module is connected to the input of only one or two neighboring functional circuit modules. Even when this is the case, the interconnection is usually accomplished by means of the general interconnect structure, which is used to connect the output of one functional circuit module to an input of one or more neighboring functional circuit modules.

Use of the general interconnect structure to implement these types of connections reduces the amount of general interconnect structure available for use in making other, non-local connections. In addition, interconnection of neighboring functional circuit modules in this manner requires the use of several of the programmable elements which are used in the general interconnect architecture.

In most integrated circuit architectures employing user-programmable interconnect elements, at least two of the interconnect elements must be used to implement the connection, one from the output node of the driving functional circuit module to on of the general interconnect conductor, and one from the general interconnect conductor to the input node of the driven functional circuit module. Depending on the type of interconnect element used, the resistance of the connecting path due to the interconnect element may increase enough to cause speed performance degradation.

In addition, in all user configurable logic array circuits which allow interconnection between a plurality of functional circuit modules to configure a desired circuit, the issue of interconnect flexibility versus speed is an important one. It is likely that critical paths will be encountered by a designer during routing of the interconnections between a number of functional circuit modules.

A critical path is one where timing of the arrival of signals to a particular circuit module is important to the proper functioning of that module. In some cases, the interconnect structure available to the designer to supply the signals in the critical path is insufficient to assure that the timing requirements of the circuit module are met.

There has been some degree of recognition of this problem in the prior art and there have been attempts made to solve this problem. United States Patent No. 4,642,487 to Carter is an example of the prior art attempts to provide a local interconnect structure for use in a user programmable interconnect architecture including an array of function circuit modules. This prior art approach provides for direct connection of the output of one functional circuit module to the inputs of one or more adjacent function circuit modules.

While approaches like the above-mentioned prior art approach have been found to be useful in user-programmable interconnect architectures, there remains room for improvement.

## BRIEF DESCRIPTION OF THE INVENTION

According to the present invention, an internal node of a first functional circuit module in an array of functional circuit modules is connected to a first input of a multiplexer circuit associated with a second functional circuit module. The internal node is located upstream from the output buffer of the second functional circuit module. The internal node may carry a signal which is logically related to the signal appearing at the output of the functional circuit module, or may carry a signal which is related to the output or function of the module in some other manner. For example, the internal node may be a node upstream from the output buffer of the functional circuit module, and the logical relationship between the signal at that node and the signal appearing at the output of the module may be one of delay or delay and inversion. In another example, the internal node may be the carry output from an adder configured from elements in the functional circuit module. In this example the signal at the internal node is related to the function of the module, and not necessarily logically related to the output of the module alone.

A second input lead of the multiplexer circuit is connected to an input lead of the second functional circuit module in the array. Other inputs to the multiplexer may be connected to internal nodes in other (third, and fourth etc.) neighboring functional circuit modules. The output of the multiplexer circuit is connected to the input node of the second functional circuit module with which the input lead is associated.

By programming the multiplexer control inputs using the same programmable elements which are used to make the interconnections in the general interconnect architecture of the array, the input node of the first functional circuit module may be connected to the input lead and to other circuit nodes in the array via the general interconnect structure, or may be connected to the internal nodes of one of a number of neighboring functional circuit modules in a manner which bypasses both the output buffer stage of the other functional module and the general interconnect structure.

## BRIEF DESCRIPTION OF THE DRAWINGS

FIG. 1 is a block diagram showing typical interconnections between neighboring functional circuit modules in a portion of a prior art user-programmable array of functional circuit modules.

FIG. 2 is a block diagram of a single functional circuit module for use in an array of functional circuit modules, such as the array shown in FIG 1 configured according to one presently preferred embodiment of the invention.

FIG. 3 is a block diagram of a presently preferred embodiment of the invention showing a portion of a user-configurable array architecture like that shown in FIG. 1, incorporating the functional circuit module of FIG. 2.

FIGS. 4a and 4b are block diagrams showing direct connections between two neighboring functional circuit modules according to alternate embodiments of the present invention wherein internal circuit nodes of first functional circuit modules carrying different types of signals are directly connected to at least one neighboring functional circuit module.

## DETAILED DESCRIPTION OF A PREFERRED EMBODIMENT

Those of ordinary skill in the art will realize that the following description of the present invention is illustrative only and not in any way limiting. Other embodiments of the invention will readily suggest themselves to such skilled persons and are intended to fall within the scope of the present invention which is limited only by the appended claims.

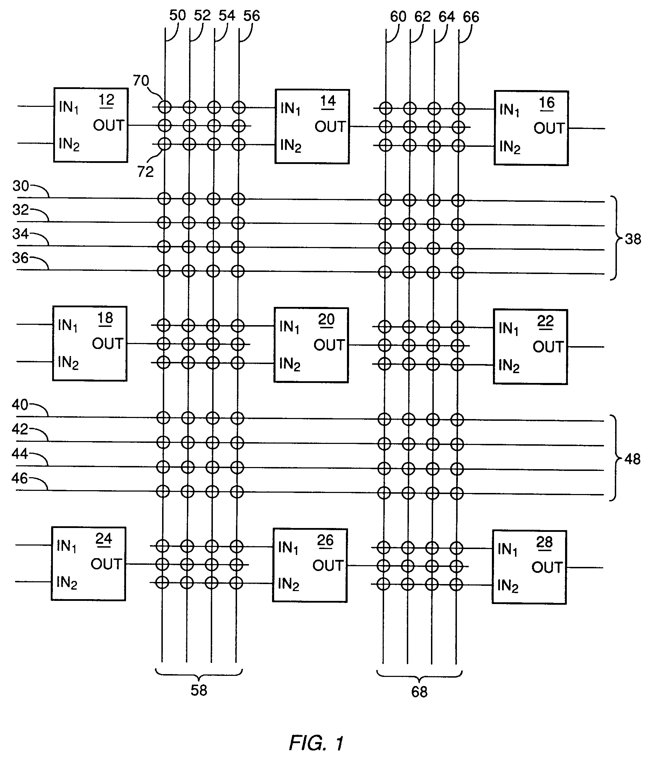

Referring first to FIG. 1, an array 10 of functional circuit modules is shown to illustrate the environment in which the present invention is useful. Array 10 includes functional circuit modules 12, 14, 16, 18, 20, 22, 24, 26, and 28, arranged in three rows and three columns. As shown in FIG. 1, functional circuit modules 12, 14, 16, 18, 20, 22, 24, 26, and 28 each have two inputs ($IN_1$ and $IN_2$), and one output (OUT).

As will be appreciated by those of ordinary skill in the art, in an actual array, the number of functional circuit modules and the number of rows and columns will vary according to the needs of the particular design. In addition, the number of inputs and outputs provided on each functional circuit module will also be a matter of design choice.

A general interconnect structure comprising a network of segmented conductors is typically provided in a user-configurable array circuit such as the one depicted in FIG. 1. Accordingly, horizontal conductors 30, 32, 34, and 36 are shown in a first horizontal interconnect channel 38 and horizontal conductors 40, 42, 44, and 46 are shown in a second horizontal interconnect channel 48. Similarly, vertical conductors 50, 52, 54, and 56 are shown in a first vertical interconnect channel 58 and vertical conductors 60, 62, 64, and 66 are shown in a second vertical interconnect channel 68.

Those of ordinary skill in the art will recognize that, in an actual user-configurable circuit array, selected ones of the horizontal and vertical conductors will be divided into two or more segments to add to the versatility of the interconnect architecture. Disclosure of the details of such segmentation are not necessary to facilitate an understanding of the present invention and are thus not shown in FIG. 1 in order to avoid over-complicating the disclosure.

The horizontal and vertical conductors and the inputs and outputs of the functional circuit modules of a user-configurable circuit array are connected to one another using programmable interconnect elements located between the elements which are to be connected together. Such programmable elements may include, but are not limited to, normally open antifuse elements, normally shorted fuse elements, EEPROM, EPROM and SRAM and other memory elements, MOS transistors driven by registers or memory elements, or similar means. These programmable interconnect elements are shown symbolically in FIG. 1 by circles located at the intersections of the interconnect conductors with each other and with input and output leads of the functional circuit modules. An exemplary programmable interconnect element is indicated by reference numeral 70.

When using an array such as that depicted in FIG. 1, a designer is likely to make connections between inputs and outputs of functional circuit modules located in various parts of the array. This is accomplished by programming programmable interconnect elements. The designer will often wish to effect connections between neighboring functional circuit modules. According to the prior art, effecting such connections is accomplished by programming the appropriate interconnect element or elements.

For example, to connect the output of functional circuit module 12 to the $IN_1$ input of functional circuit module 14, programmable interconnect elements 70 and 72 could be programmed. From an examination of FIG. 1, those of ordinary skill in the art will recognize that other combinations of programmable interconnect elements could be used, but any such combination will require programming of two elements, one to connect the output of functional interconnect element 12 to the general interconnect conductor and one to connect the general interconnect conductor to the input of functional circuit module 14.

Since no known programmable interconnect element has a zero-ohm resistance in its on state, the use of each programmable interconnect element in a circuit connection path adds an incremental impedance to the circuit paths. In the particular example shown in FIG. 1, there are numerous elements which contribute to signal delay from the output of functional circuit module 12 to the $IN_1$ input of functional circuit module 14.

The first element contributing to the delay path is programmable element 72, used to connect the output lead of functional circuit module 12 to general interconnect line 50. The second element contributing to the delay path is programmable element 70, used to connect general interconnect line 50 to the input lead $IN_1$ of functional circuit module 14. These delay elements are inherent in the programmable interconnect elements themselves and are a necessary byproduct of the use of a general interconnect architecture such as is shown in FIG. 1

The last element contributing to signal delay, unseen in FIG. 1, is the delay caused by the output buffer section of functional circuit module 12 itself. When designing circuitry to be used in functional circuit modules for an array of the type shown in FIG. 1, the designer take into account the many variations in use of functional circuit modules which will occur over a very wide range of application circuit scenarios. In order to provide for a wide range of different uses to which such functional module circuits will be put, such circuits are designed having output buffers to provide for the maximum drive or fan out requirements allowed by the design specifications for the functional circuit modules.

The prior art attempts to deal with the problem of local interconnect in an array of functional circuit modules in a user-programmable architecture are exemplified by United States Patent No. 4,642,487 to Carter. According to the teachings of the Carter patent, the utilization of the general interconnect conductors is reduced by providing a special vertical interconnect conductor which allows one output lead of a functional circuit module to be directly connected to any input lead of the functional circuit module immediately above it or below it in the array by programming one programmable interconnect element in the circuit path. In addition, a second special horizontal interconnect conductor is provided to allow one output lead of a functional circuit module to be directly connected to any input lead of the functional circuit module immediately to its right in the array by programming one programmable interconnect element in the circuit path.

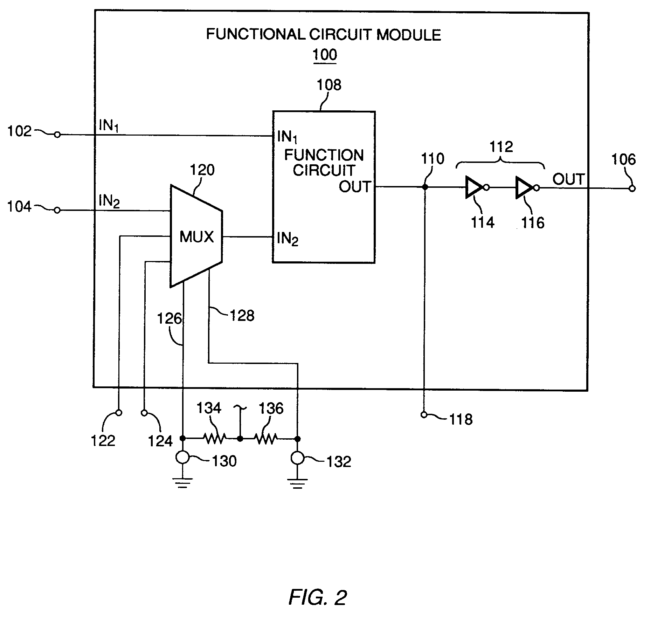

The present invention, as exemplified by the embodiment disclosed with respect to FIG. 2, represents a significant improvement over prior art interconnection schemes including the one disclosed in United States Patent No. 4,642,487 to Carter. Referring now to FIG. 2, a block diagram of an illustrative single functional circuit module configured according to the present invention is shown. Functional circuit module 100 includes input $IN_1$, shown at reference numeral 102, input $IN_2$, shown at reference numeral 104, and output 106 like the functional circuit modules shown in FIG. 1. Although two inputs and one output are shown to illustrate the principles of the present invention, those of ordinary skill in the art will readily recognize that additional inputs and outputs could be provided without departing from the spirit of the invention.

The heart of functional circuit module 100 is function circuit 108. Function circuit 108 may be a circuit capable of performing any one of a wide variety of functions. There are numerous available circuits described in the literature which are capable of performing these functions.

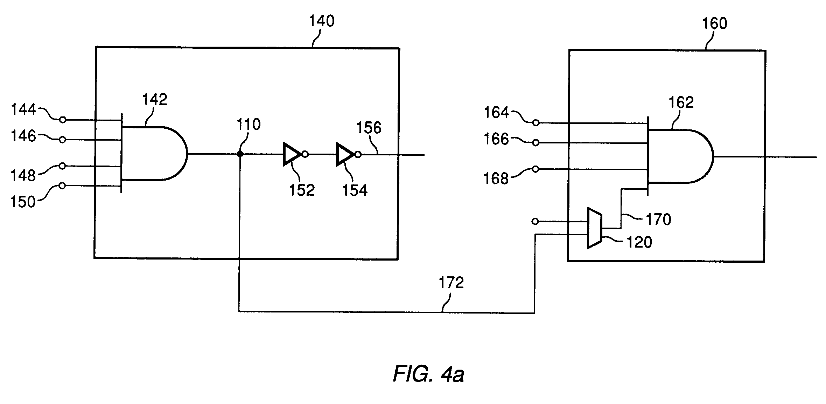

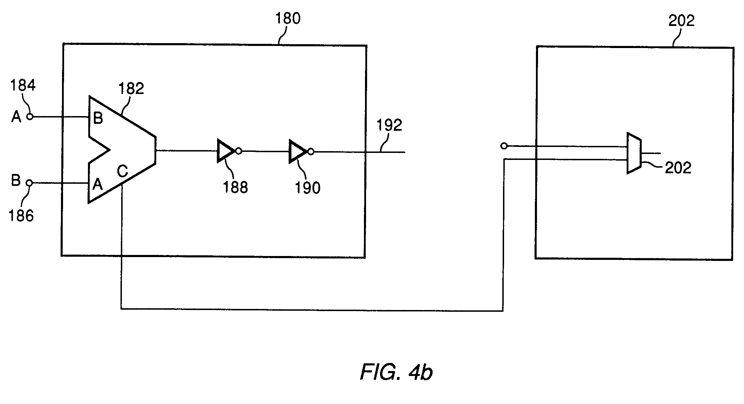

The pre-buffered output of function circuit 108 appears at internal circuit node 110 of function circuit module 100. In prior art circuit modules, internal circuit node 110 is not made available to a user, but serves to drive output buffer 112, comprising inverters 114 and 116. The output of buffer 116 is connected to output node 106 of functional circuit module 100. According to one aspect of the present invention and as will be more fully disclosed with reference to FIGS. 4a and 4b, internal circuit node 110 in functional circuit module 100, related to the signal at the output node of functional circuit module by two logic inversions and the delay associated therewith, is brought to the outside of functional circuit module 100 on line 118.

As shown in FIG. 2, input $IN_2$ 104 is not directly connected to an input of function circuit 108, but is instead connected to one input of multiplexer 120. The output of multiplexer 120 is connected to the input of function circuit 108. Additional inputs 122 and 124 of multiplexer 120 are brought to the outside of functional circuit module 100, as are control lines 126 and 128 from the control inputs of multiplexer 120. The number of control lines provided to multiplexer 120 is purely a function of the number of inputs provided to multiplexer 120. In the example shown in FIG. 2, two control lines are used to select from one of three inputs to multiplexer 120.

From an examination of FIG. 2, it is apparent that multiplexer 120 controls the source of input for the second input of function circuit 108 in functional circuit module 100. The selection may be made by programming one or more programmable elements 130 and 132 connected to the control lines 126 and 128. Programmable elements 130 and 132 may be programmed using conventional programming circuitry used with user-programmable circuit arrays. Such programming circuitry is well known to those of ordinary skill in the art and will not be disclosed herein to avoid overcomplicating the disclosure.

If it is assumed that programmable elements 130 and 132 are normally-open circuits prior to programming, it may be seen that, for unprogrammed ones of programmable elements 130 and 132, pullup resistors 134 and 136 maintain a logic high level on control input lines 126 and 128, respectively. If one or both of programmable elements 130 and 132 are programmed, it is apparent that a logic low level appears on the control line associated with the programmed element. It is in this manner that multiplexer 120 is controlled. Those of ordinary skill in the art will recognize that the programmable elements 130 and 132 which determine the signal path are themselves not in the signal path and hence do not contribute to any signal delay.

Those of ordinary skill in the art will recognize that, by using a functional circuit module including the elements shown in functional circuit module 100 of FIG. 2, connections may be made between selected functional circuit modules by using internal node 110 and multiplexer 120 in a manner which eliminates programmable elements from the signal path. Employing such functional circuit modules allows for an array architecture with greatly increased local interconnect capabilities. The delay encountered by the signal path through multiplexer 120 is less than the delay which would be encountered by the signal by passage through the two inverters 114 and 116 in series with the one or two programmable interconnect elements through which the signal would have to pass if prior art interconnection methods are utilized.

Those of ordinary skill in the art will recognize that, according to another embodiment of the invention, multiplexer 120 may be eliminated and the connection from internal node 110 of a first functional circuit module may be directly connected to an input lead 102 or 104 of one or more other functional circuit modules. However, such an embodiment accomplishes its purpose at the expense of some circuit interconnect versatility.

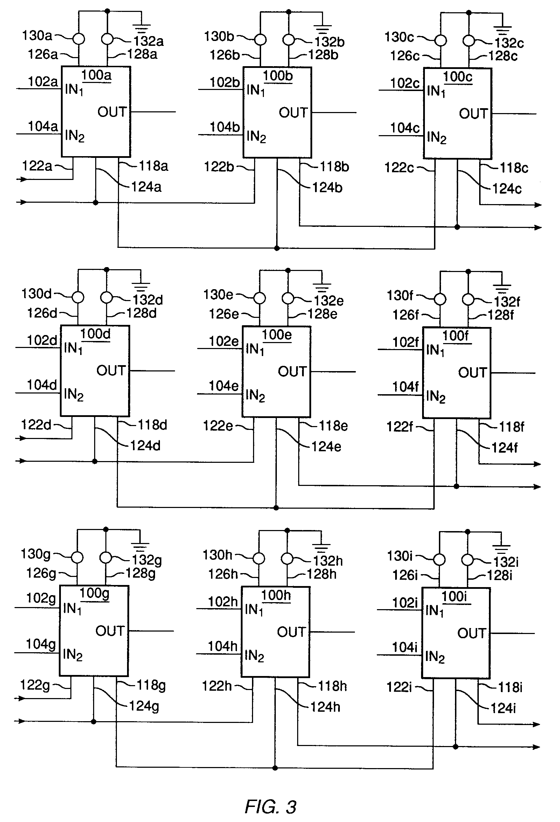

The advantage obtained by use of the present invention may be most easily seen by examining the invention in an array environment in which it is likely to be encountered. Referring now to FIG. 3, the same portion of array 10 as shown in FIG. 1 is shown to include functional circuit modules 100a-100i, arranged in three rows and three columns. As shown in FIG. 3, functional circuit modules 100a-100i each have two inputs ($IN_1$ and $IN_2$), and one output (OUT). The general interconnect architecture of FIG. 1 including horizontal and vertical interconnect conductor channels 38, 48, 58, and 68 is present in the array, but have been omitted from FIG. 3 to more clearly show the present invention.

Functional circuit modules 100a-100i may preferably be as shown in FIG. 2 and thus include inputs 102a-102i, 104a-104i, internal circuit node outputs 118a-118i, multiplexer inputs 122a-122i and 124a-124i, multiplexer control lines 126a-126i and 128a-128i, and their associated programmable elements 130a-130i and 132a-132i (pullup resistors 134 and 136 have been omitted from FIG. 3 to avoid overcomplicating the figure, but those of ordinary skill in the art will recognize that they may be present in an actual embodiment). The additional conductors and their connections to the various circuit nodes necessary for configuring an enhanced local interconnect architecture according to the present invention are shown in FIG. 3.

In the architectural example shown in FIG. 3, direct connections are possible between any functional circuit module and two of its neighbors using the local interconnect of the present invention. Thus, in the first row of the array 10 of FIG. 3, the internal circuit node line 118a of functional circuit module 100a is connected to the multiplexer input 122b of functional circuit module 100b and the multiplexer input line 124c of functional circuit module 100c. Similarly, the internal circuit node line 118b of functional circuit module 100b is connected to the multiplexer input 124c of functional circuit module 100c and is shown extending past the right edge of FIG. 3 to make a connection to a multiplexer input line of an additional functional circuit module in the array (not shown). Multiplexer inputs 122a and 124a of functional circuit module 100a are shown connected to lines which extend past the left edge of FIG. 3. These lines are connections from internal circuit nodes of other functional circuit modules in the array (not shown).

In the second row of the array 10 of FIG. 3, the internal circuit node line 118d of functional circuit module 100d is connected to the multiplexer input 122e of functional circuit module 100e and the multiplexer input line 124f of functional circuit module 100f. Similarly, the internal circuit node line 118e of functional circuit module 100e is connected to the multiplexer input 124f of functional circuit module 100f and is shown extending past the right edge of FIG. 3 to make a connection to a multiplexer input line of an additional functional circuit module in the array (not shown). Multiplexer inputs 122d and 124d of functional circuit module 100d are shown connected to lines which extend past the left edge of FIG. 3. These lines are connections from internal circuit nodes of other functional circuit modules in the array (not shown).

In the third of the array 10 of FIG. 3, the internal circuit node line 118g of functional circuit module 100g is connected to the multiplexer input 122h of functional circuit module 100h and the multiplexer input line 124i of functional circuit module 100i. Similarly, the internal circuit node line 118h of functional circuit module 100h is connected to the multiplexer input 124i of functional circuit module 100i and is shown extending past the right edge of FIG. 3 to make a connection to a multiplexer input line of an additional functional circuit module in the array (not shown). Multiplexer inputs 122g and 124g of functional circuit module 100g are shown connected to lines which extend past the left edge of FIG. 3. These lines are connections from internal circuit nodes of other functional circuit modules in the array (not shown).

Those of ordinary skill in the art will readily observe that, by programming appropriate ones of programmable elements 130 and/or 132, signal paths may be created which bypass the output buffers 112 in the functional circuit modules 100 and connect to the inputs of function circuits 108 in desired ones of the other functional circuit modules 100 via their internal multiplexers 120.

Numerous variations on the specific architectural example given in FIG. 3 are possible. For example, the particular number and relative location of functional circuit modules having multiplexer inputs connected to the line 118 from internal circuit node 110 of any particular functional circuit module 100 is merely a matter of design choice. The disclosure with respect to FIG. 3 should therefore be regarded as merely illustrative. Those of ordinary skill in the art will readily be able to suggest other embodiments which nonetheless remain within the scope of the present invention.

Referring now to FIGS. 4a and 4b, two illustrative examples are presented showing direct connections between two neighboring functional circuit modules according to alternate embodiments of the invention wherein internal circuit nodes of first functional circuit modules carrying different types of signals are directly connected to at least one neighboring functional circuit module. In the first example illustrated in FIG. 4a, the use of two functional modules to implement a wide gate, first functional circuit module 140 is configured to implement a multi-input gate 142 connected to inputs 144, 146, 148, and 150. The output of gate 142 is connected through output buffers 152 and 154 to output line 156 of first functional circuit module 142.

If the circuit design requires a gate wider than four inputs, a second functional circuit module 160 may be utilized in the circuit realization to supply another gate 162 having additional inputs 164, 166, 168 and 170. In a circuit according to the teachings of the prior art, the output line 156 of first functional circuit module 140 may be programmably connected to input 170 of second functional circuit module 160, but at the expense of the delay of the partial terms from the output of gate 142 due to the presence of output buffers 152 and 154. Additional delay may be introduced by whatever programmable elements are in the circuit path of the conductor 172 used to make the connection between the output node 156 of first functional circuit module 140 and the input 170 of second functional circuit module 160. The solution suggested by United States Patent No. 4,642,487 does not address the significant problem posed by this latter delay.

According to the present invention, the output of gate 142 is the internal circuit node 110 (FIG. 2) and is directly connected to input 170 of second functional circuit module 160 according to the teachings of the present invention. If utilized, a multiplexer like multiplexer 120 of FIG 2 may be the only intervening circuit element in the circuit path, thus eliminating the delay caused by output buffers 152 and 154 and whatever programmable elements would otherwise be located in the circuit path of the conductor 172 used to make the connection between the output node 156 of first functional circuit module 140 and the input 168 of second functional circuit module 160.

Referring now to FIG. 4b, a first functional circuit module 180 is configured to implement an adder 182 to add the terms appearing on its A and B inputs 184 and 186. The output of the adder 182 is connected through output buffers 188 and 190 to output line 192 of first functional circuit module 180.

According to the present invention, a carry output 194 of adder 182 may be directly connected via line 196 to a circuit node in a second functional circuit module 200, such as an input of a multiplexer 202 as disclosed herein. Depending on the anticipated circuit functions, multiplexer 202 may be located at an input to the second functional circuit module 200 or may be connected to san internal circuit node in the second functional circuit module 200. Use of the present invention to eliminate delay on signals such as the carry out signal from the adder in first functional circuit module 180 allows implementation of faster adder circuits than are presently possible.

While embodiments and applications of this invention have been shown and described, it would be apparent to those skilled in the art that many more modifications than mentioned above are possible without departing from the inventive concepts herein. The invention, therefore, is not to be restricted except in the spirit of the appended claims.

**Claims**

1. A functional circuit module for use in a user-programmable array of functional circuit modules, said functional circuit module including:

at least two signal inputs driving function circuitry;

at least one output driven from said function circuitry by an output buffer and an internal circuit node between said function circuitry and said output buffer;

a multiplexer interposed between a first one of said signal inputs and said function circuitry, said multiplexer having a plurality of multiplexer inputs, a multiplexer output, and at least one control input, a first one of said multiplexer inputs connected to said first one of said at least two signal inputs, said multiplexer output connected to said function circuitry;

user programmable means connected to said at least one control input of said multiplexer for selecting either said first one of said at least two signal inputs or one other of said plurality of multiplexer inputs to be passed to said multiplexer output.

2. A functional circuit module for use in a user-programmable array of functional circuit modules, said functional circuit module including:

at least two signal inputs driving function circuitry;

at least one output driven from said function circuitry by an output buffer and an internal circuit node between said function circuitry and said output buffer;

means for providing access to said internal circuit node outside of said functional circuit module.

3. In a user-programmable array of functional circuit modules including a plurality of said functional circuit modules, each of said functional circuit modules having at least two signal inputs driving function circuitry, at least one output driven from said function circuitry by an output buffer and an internal circuit node between said function circuitry and said output buffer, said array also including a general interconnect architecture, said general interconnect architecture including a plurality conductors programmably connectable to each other and to said inputs and outputs of said plurality of functional circuit modules, a local interconnect architecture for bypassing said general interconnect architecture, including:

a multiplexer in at least one of said functional circuit modules interposed between a first one of said signal inputs and said function circuitry, said multiplexer having a plurality of multiplexer inputs, a multiplexer output, and at least one control input, a first one of said multiplexer inputs connected to said first one of said at least two signal inputs, said multiplexer output connected to said function circuitry;

a conductor connecting said internal circuit node in a first one of said functional circuit modules to a second one of said multiplexer inputs in a said at least one of said functional circuit modules;

user programmable means connected to said at least one control input of said multiplexer for selecting either said first one of said at least two signal inputs or said internal circuit node.

FIG. 1

FIG. 2

FIG. 3

11

FIG. 4a

EP 0 515 043 A2

FIG. 4b